# EUROPÄISCHE PATENTANMELDUNG

(11) **EP 1 808 236 A1**
(43) Veröffentlichungstag der Anmeldung: **18.07.2007**
(21) Anmeldenummer: 06000857.0
(22) Anmeldetag: 16.01.2006
(51) Int. Cl.: B05B 15/04, C23C 4/02, F01D 5/28

(54) **Verfahren zum Abdecken von Kühlungsbohrungen, insbesondere von Turbinenschaufeln**

(71) Anmelder: SIEMENS AKTIENGESELLSCHAFT, 80333 München (DE)
(72) Erfinder: Ladru, Francis-Jurjen, Dr., 14050 Berlin (DE); Reich, Gerhard, 10717 Berlin (DE); Reymann, Helge, 14167 Berlin (DE)

(57) **Zusammenfassung**

Die Erfindung betrifft ein Verfahren zur Herstellung von Werkstücken (1), insbesondere Turbinenschaufeln, bei dem das Werkstück (1) vor dem Aufbringen einer insbesondere keramischen Beschichtung mit einer Abdeckung über Bohrungsbereiche versehen wird, die für Bohrungen (4) vorgesehen sind oder wo Bohrungen (4) vorhanden sind, welche nach der Beschichtung nachbearbeitet werden, und bei dem die Abdeckung nach dem Beschichten wieder entfernt wird, welches dadurch gekennzeichnet ist, dass zur Herstellung der Abdeckung über die Bohrungsbereiche wenigstens ein stab- oder streifenförmiges Abdeckelement (6) gelegt und an dem Werkstück (1) mittels Klebstoff (5) befestigt wird, der sich zumindest über die Bohrungsbereiche erstreckt, wobei Abdeckelement(e) (6) und Klebstoff (5) gegenüber den bei der Beschichtung herrschenden Temperaturen beständig sind.

## Beschreibung

Die Erfindung betrifft ein Verfahren zur Herstellung von Werkstücken, insbesondere von Turbinenschaufeln, bei dem das Werkstück vor dem Aufbringen einer insbesondere keramischen Beschichtung mit einer Abdeckung über Bohrungsbereiche versehen wird, die für Bohrungen vorgesehen sind oder wo Bohrungen vorhanden sind, welche nach der Beschichtung nachbearbeitet werden, und bei dem die Abdeckung nach dem Beschichten wieder entfernt wird.

Hochbelastete Werkstücke wie beispielsweise Leit- und Laufschaufeln für Turbinen, insbesondere Gasturbinen, werden zur Verbesserung ihrer Temperatur- und/oder Abrasionsfestigkeit mit hierfür geeigneten Keramiken beschichtet. Die Beschichtung geschieht mittels Sprühbeschichtungsvorrichtungen, in der das Werkstück sprühbeschichtet wird. Beispiele für Sprühbeschichtungsverfahren sind das atmosphärische Plasmasprühen (APS) und das Hochgeschwindigkeits-Sauerstoff-Brennstoff-Sprühen (HVOF) (vgl. Ullmann's Encyclopaedia of Industrial Chemistry, 2003, Band 21, S. 573 und 575).

Vor allem für Gasturbinen bestimmte Turbinenschaufeln werden insbesondere dann, wenn die Gasturbine bei hohen Temperaturen betrieben wird, luftgekühlt. Hierzu wird Kühlluft in die Hohlräume der Turbinenschaufeln eingeleitet. Bei der so genannten Filmkühlung wird die Kühlluft über Filmkühllöcher durch die Wandung der Turbinenschaufel nach außen geleitet, so dass dort eine als Isolierschicht wirkende Luftschicht entsteht. Beispiele für solche Turbinenschaufeln finden sich in der DE 692 10 892 T2, DE 36 42 789 A1 und DE 694 20 582 T2.

Das Herstellen der Bohrungen kann vor dem Aufbringen der Beschichtung geschehen. Nach dem Beschichten werden die Bohrungen mittels Elektroerosion speziell ausgeformt (shaped holes), um die Entstehung eines Luftfilms zu begünstigen. Da eine keramische Beschichtung der Bohrungen dies behindern würde, werden die Bohrungen für die Sprühbeschichtung abgedeckt, beispielsweise mittels großflächiger Bleche (vgl. DE 698 15 644 T2). Dies geschieht auch dann, wenn die Bohrungen alternativ dazu erst nach dem Beschichtungsvorgang gefertigt werden, denn die Keramikbeschichtung behindert auch das Bohren. In beiden Fällen wird dies mit dem Nachteil erkauft, dass große Flächen der Turbinenschaufel mangels Beschichtung gegen Wärmeeintrag ungeschützt sind.

Der Erfindung liegt die Aufgabe zugrunde, ein Verfahren bereitzustellen, mit dem sich Werkstücke herstellen lassen, die insbesondere im Bereich der Bohrungen weitgehend vollständig beschichtet sind.

Diese Aufgabe wird erfindungsgemäß dadurch gelöst, dass zur Herstellung der Abdeckung über die Bohrungsbereiche wenigstens ein stab- oder streifenförmiges Abdeckelement gelegt und an der Turbinenschaufel mittels Klebstoff befestigt wird, der sich zumindest über die Bohrungsbereiche erstreckt, wobei Abdeckelement(e) und Klebstoff gegenüber den bei der Beschichtung herrschenden Temperaturen beständig sind. Grundgedanke der Erfindung ist es also, die Bohrungsbereiche - also entweder die schon vorhandenen Bohrungen oder die Bereiche, in denen nach der Beschichtung Bohrungen eingebracht werden - mit einem vorzugsweise aus Kunststoff bestehenden Klebstoff abzudecken und dabei ein Abdeckelement an dem Werkstück zu befestigen, das sich über die Bohrungsbereiche oder einen Teil derselben erstreckt. Auf diese Weise werden die Bereiche, die wegen der Abdeckung(en) nicht beschichtet werden, auf ein Minimum reduziert mit der Folge, dass das Werkstück wesentlich besser gegen Wärmeeintrag geschützt ist als die nach dem vorbekannten Verfahren hergestellten Werkstücke. Da auch der Klebstoff durch das Abdeckelement abgedeckt ist, ist der Klebstoff nach Entfernung des Abdeckelements zumindest teilweise beschichtungsfrei und kann somit auf einfache Weise entfernt werden.

In Ausbildung der Erfindung ist vorgesehen, dass ein bzw. mehrere Abdeckelement(e) verwendet werden, die sich über eine Reihe von Bohrungsbereichen erstrecken. Wegen der stab- oder streifenförmigen Ausbildung des Abdeckelements wird die Beschichtung zwischen den Bohrungsbereichen nur unwesentlich unterbrochen. Als Abdeckelemente eignen sich insbesondere Abdeckdrähte, vorzugsweise aus einem geeigneten Metall. Sie können aber aus einem temperaturbeständigen Kunststoff wie PTFE oder aus Keramik, Glasfaser oder Materialien ähnlicher Temperaturbeständigkeit und Wärmekapazität bzw. Wärmeleitfähigkeit bestehen.

Um die abgedeckten Bereiche möglichst klein zu halten, sollte der Klebstoff so aufgetragen werden, dass er ausschließlich die Bohrungsbereiche abdeckt, d.h. entweder die Bereiche, wo Bohrungen vorgesehen sind, oder die von vorhandenen Bohrungen eingenommenen Bereiche, in denen diese Bohrungen vollständig ausgefüllt werden.

Die Entfernung des Klebstoffs geschieht zweckmäßigerweise durch Ausbrennen nach vorheriger Entfernung des Abdeckelements bzw. der Abdeckelemente. Damit der Klebstoff den Temperaturen beim Beschichtungsvorgang standhält, sollte er bis zu 250°C beständig sein. Als Klebstoffe kommen z.B. solche in Frage, die unter UV-Licht aushärten.

Es zeigen:
- Figur 1: ein Bauteil, das erfindungsgemäß behandelt wird,
- Figur 2: eine Turbinenschaufel,
- Figur 3: eine Brennkammer und
- Figur 4: eine Gasturbine.

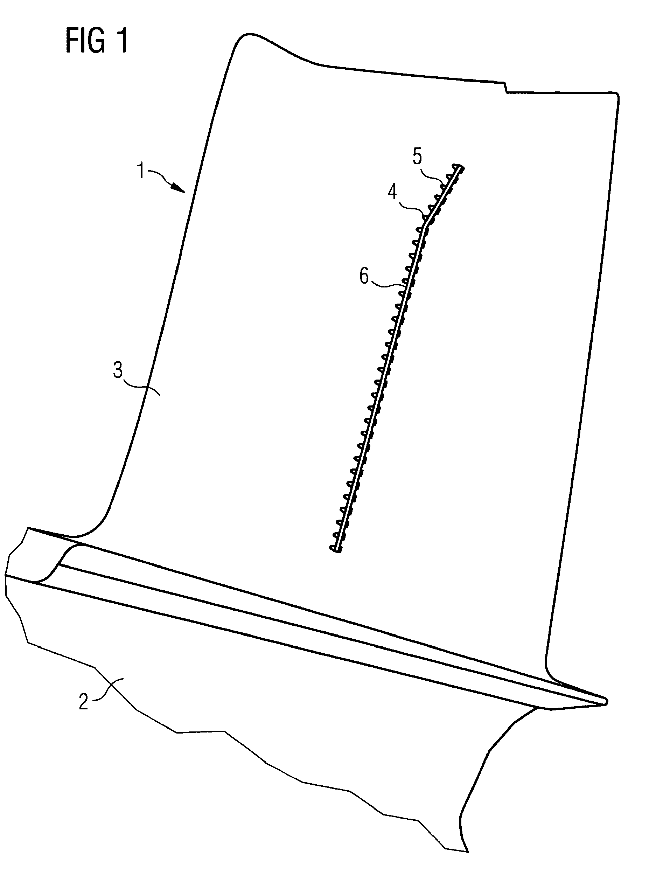

In der Figur 1 ist die Erfindung anhand eines Ausführungsbeispiels näher veranschaulicht. Die Zeichnung zeigt als Werkstück eine Turbinenschaufel 1, bestehend aus einem Schaufelfuß 2 und einem daran anschließenden Schaufelblatt 3. Etwa in der Mitte des Schaufelblatts 3 erstreckt sich radial - d.h. parallel zur Vorderkante des Schaufelblatts 3 - eine Reihe von Bohrungen - beispielhaft mit 4 bezeichnet -, die nebeneinander in gleichem Abstand angeordnet sind. Die Bohrungen 4 stehen in Verbindung mit Kühlluftkanälen, die innerhalb des Schaufelblatts 3 verlaufen und nach Einbau in die Gasturbine mit Kühlluft versorgt werden, die dann über die Bohrungen 4 unter Bildung eines sich stromabwärts erstreckenden Luftfilms ausströmt.

Zum Schutz gegen Beschichtungsmaterial sind die Bohrungen 4 mit einem Klebstoff - beispielhaft mit 5 bezeichnet - gefüllt. In noch klebfähigem Zustand wird über die Bohrungen 4 ein Abdeckdraht 6 gelegt, der sich mit dem Klebstoff 5 verbindet und hierdurch am Schaufelblatt 3 fixiert wird. Danach wird das Schaufelblatt 3 in einer Sprühbeschichtungsanlage mit keramischem Material beschichtet. Dies legt sich auch über die freien Flächen des Klebstoffs 5 und über den Abdeckdraht 6. Nach Fertigstellung der Beschichtung wird der Abdeckdraht 6 abgerissen, so dass der verbleibende Klebstoff 5 an den Stellen, wo der Abdeckdraht 6 verlief, beschichtungsfrei ist. Der Klebstoff 5 kann dann durch Erhitzen des Schaufelblatts 3 ausgebrannt werden, so dass die Bohrungen 4 klebstofffrei werden. Anschließend können die Bohrungen mittels Elektroerosion in eine bestimmte, für die Luftfilmbildung günstige Form gebracht werden, da die Bohrungswandungen frei von Keramikbeschichtungen sind.

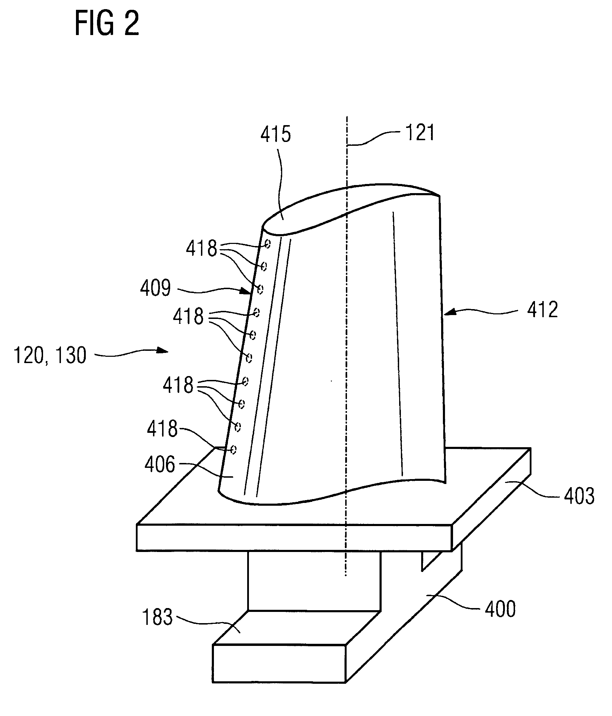

Die Figur 2 zeigt in perspektivischer Ansicht eine Laufschaufel 120 oder Leitschaufel 130 einer Strömungsmaschine, die sich entlang einer Längsachse 121 erstreckt.

Die Strömungsmaschine kann eine Gasturbine eines Flugzeugs oder eines Kraftwerks zur Elektrizitätserzeugung, eine Dampfturbine oder ein Kompressor sein.

Die Schaufel 120, 130 weist entlang der Längsachse 121 aufeinander folgend einen Befestigungsbereich 400, eine daran angrenzende Schaufelplattform 403 sowie ein Schaufelblatt 406 und eine Schaufelspitze 415 auf.
Als Leitschaufel 130 kann die Schaufel 130 an ihrer Schaufelspitze 415 eine weitere Plattform aufweisen (nicht dargestellt).

Im Befestigungsbereich 400 ist ein Schaufelfuß 183 gebildet, der zur Befestigung der Laufschaufeln 120, 130 an einer Welle oder einer Scheibe dient (nicht dargestellt).
Der Schaufelfuß 183 ist beispielsweise als Hammerkopf ausgestaltet. Andere Ausgestaltungen als Tannenbaum- oder Schwalbenschwanzfuß sind möglich.
Die Schaufel 120, 130 weist für ein Medium, das an dem Schaufelblatt 406 vorbeiströmt, eine Anströmkante 409 und eine Abströmkante 412 auf.

Bei herkömmlichen Schaufeln 120, 130 werden in allen Bereichen 400, 403, 406 der Schaufel 120, 130 beispielsweise massive metallische Werkstoffe, insbesondere Superlegierungen verwendet.
Solche Superlegierungen sind beispielsweise aus der EP 1 204 776 B1, EP 1 306 454, EP 1 319 729 A1, WO 99/67435 oder WO 00/44949 bekannt; diese Schriften sind bzgl. der chemischen Zusammensetzung der Legierung Teil der Offenbarung.
Die Schaufel 120, 130 kann hierbei durch ein Gussverfahren, auch mittels gerichteter Erstarrung, durch ein Schmiedeverfahren, durch ein Fräsverfahren oder Kombinationen daraus gefertigt sein.

Werkstücke mit einkristalliner Struktur oder Strukturen werden als Bauteile für Maschinen eingesetzt, die im Betrieb hohen mechanischen, thermischen und/oder chemischen Belastungen ausgesetzt sind.
Die Fertigung von derartigen einkristallinen Werkstücken erfolgt z.B. durch gerichtetes Erstarren aus der Schmelze. Es handelt sich dabei um Gießverfahren, bei denen die flüssige metallische Legierung zur einkristallinen Struktur, d.h. zum einkristallinen Werkstück, oder gerichtet erstarrt.
Dabei werden dendritische Kristalle entlang dem Wärmefluss ausgerichtet und bilden entweder eine stängelkristalline Kornstruktur (kolumnar, d.h. Körner, die über die ganze Länge des Werkstückes verlaufen und hier, dem allgemeinen Sprachgebrauch nach, als gerichtet erstarrt bezeichnet werden) oder eine einkristalline Struktur, d.h. das ganze Werkstück besteht aus einem einzigen Kristall. In diesen Verfahren muss man den Übergang zur globulitischen (polykristallinen) Erstarrung meiden, da sich durch ungerichtetes Wachstum notwendigerweise transversale und longitudinale Korngrenzen ausbilden, welche die guten Eigenschaften des gerichtet erstarrten oder einkristallinen Bauteiles zunichte machen.
Ist allgemein von gerichtet erstarrten Gefügen die Rede, so sind damit sowohl Einkristalle gemeint, die keine Korngrenzen oder höchstens Kleinwinkelkorngrenzen aufweisen, als auch Stängelkristallstrukturen, die wohl in longitudinaler Richtung verlaufende Korngrenzen, aber keine transversalen Korngrenzen aufweisen. Bei diesen zweitgenannten kristallinen Strukturen spricht man auch von gerichtet erstarrten Gefügen (directionally solidified structures).
Solche Verfahren sind aus der US-PS 6,024,792 und der EP 0 892 090 A1 bekannt; diese Schriften sind bzgl. des Erstarrungsverfahrens Teil der Offenbarung.

Ebenso können die Schaufeln 120, 130 Beschichtungen gegen Korrosion oder Oxidation aufweisen, z. B. (MCrAlX; M ist zumindest ein Element der Gruppe Eisen (Fe), Kobalt (Co), Nickel (Ni), X ist ein Aktivelement und steht für Yttrium (Y) und/oder Silizium und/oder zumindest ein Element der Seltenen Erden, bzw. Hafnium (Hf)). Solche Legierungen sind bekannt aus der EP 0 486 489 B1, EP 0 786 017 B1, EP 0 412 397 B1 oder EP 1 306 454 A1, die bzgl. der chemischen Zusammensetzung der Legierung Teil dieser Offenbarung sein sollen.
Die Dichte liegt vorzugsweise bei 95% der theoretischen Dichte.

Auf der MCrAlX-Schicht (als Zwischenschicht oder als äußerste Schicht) bildet sich eine schützende Aluminiumoxidschicht (TGO = thermal grown oxide layer).

Auf der MCrAlX kann noch eine Wärmedämmschicht vorhanden sein, die vorzugsweise die äußerste Schicht ist, und besteht beispielsweise aus ZrO₂, Y₂O₃-ZrO₂, d.h. sie ist nicht, teilweise oder vollständig stabilisiert durch Yttriumoxid und/oder Kalziumoxid und/oder Magnesiumoxid.
Die Wärmedämmschicht bedeckt die gesamte MCrAlX-Schicht. Durch geeignete Beschichtungsverfahren wie z.B. Elektronenstrahlverdampfen (EB-PVD) werden stängelförmige Körner in der Wärmedämmschicht erzeugt.
Andere Beschichtungsverfahren sind denkbar, z.B. atmosphärisches Plasmaspritzen (APS), LPPS, VPS oder CVD. Die Wärmedämmschicht kann poröse, mikro- oder makrorissbehaftete Körner zur besseren Thermoschockbeständigkeit aufweisen. Die Wärmedämmschicht ist also vorzugsweise poröser als die MCrAlX-Schicht.

Wiederaufarbeitung (Refurbishment) bedeutet, dass Bauteile 120, 130 nach ihrem Einsatz gegebenenfalls von Schutzschichten befreit werden müssen (z.B. durch Sandstrahlen). Danach erfolgt eine Entfernung der Korrosions- und/oder Oxidationsschichten bzw. -produkte. Gegebenenfalls werden auch noch Risse im Bauteil 120, 130 repariert. Danach erfolgt eine Wiederbeschichtung des Bauteils 120, 130 und ein erneuter Einsatz des Bauteils 120, 130.

Die Schaufel 120, 130 kann hohl oder massiv ausgeführt sein. Wenn die Schaufel 120, 130 gekühlt werden soll, ist sie hohl und weist ggf. noch Filmkühllöcher 418 (gestrichelt angedeutet) auf.

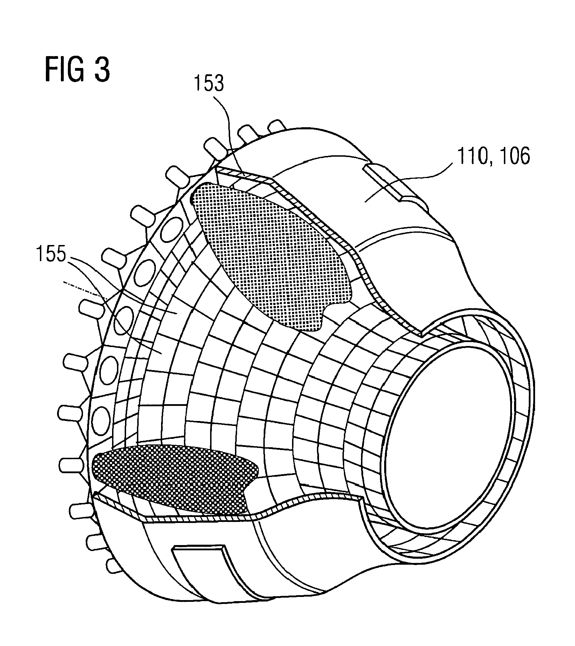

Die Figur 3 zeigt eine Brennkammer 110 einer Gasturbine. Die Brennkammer 110 ist beispielsweise als so genannte Ringbrennkammer ausgestaltet, bei der eine Vielzahl von in Umfangsrichtung um eine Rotationsachse 102 herum angeordneten Brennern 107 in einen gemeinsamen Brennkammerraum 154 münden, die Flammen 156 erzeugen. Dazu ist die Brennkammer 110 in ihrer Gesamtheit als ringförmige Struktur ausgestaltet, die um die Rotationsachse 102 herum positioniert ist.

Zur Erzielung eines vergleichsweise hohen Wirkungsgrades ist die Brennkammer 110 für eine vergleichsweise hohe Temperatur des Arbeitsmediums M von etwa 1000°C bis 1600°C ausgelegt. Um auch bei diesen, für die Materialien ungünstigen Betriebsparametern eine vergleichsweise lange Betriebsdauer zu ermöglichen, ist die Brennkammerwand 153 auf ihrer dem Arbeitsmedium M zugewandten Seite mit einer aus Hitzeschildelementen 155 gebildeten Innenauskleidung versehen.
Jedes Hitzeschildelement 155 aus einer Legierung ist arbeitsmediumsseitig mit einer besonders hitzebeständigen Schutzschicht (MCrAlX-Schicht und/oder keramische Beschichtung) ausgestattet oder ist aus hochtemperaturbeständigem Material (massive keramische Steine) gefertigt.
Diese Schutzschichten können ähnlich der Turbinenschaufeln sein, also bedeutet beispielsweise MCrAlX: M ist zumindest ein Element der Gruppe Eisen (Fe), Kobalt (Co), Nickel (Ni), X ist ein Aktivelement und steht für Yttrium (Y) und/oder Silizium und/oder zumindest ein Element der Seltenen Erden, bzw. Hafnium (Hf). Solche Legierungen sind bekannt aus der EP 0 486 489 B1, EP 0 786 017 B1, EP 0 412 397 B1 oder EP 1 306 454 A1, die bzgl. der chemischen Zusammensetzung der Legierung Teil dieser Offenbarung sein sollen.

Auf der MCrAlX kann noch eine beispielsweise keramische Wärmedämmschicht vorhanden sein und besteht beispielsweise aus ZrO₂, Y₂O₃-ZrO₂, d.h. sie ist nicht, teilweise oder vollständig stabilisiert durch Yttriumoxid und/oder Kalziumoxid und/oder Magnesiumoxid.
Durch geeignete Beschichtungsverfahren wie z.B. Elektronenstrahlverdampfen (EB-PVD) werden stängelförmige Körner in der Wärmedämmschicht erzeugt.

Andere Beschichtungsverfahren sind denkbar, z.B. atmosphärisches Plasmaspritzen (APS), LPPS, VPS oder CVD. Die Wärmedämmschicht kann poröse, mikro- oder makrorissbehaftete Körner zur besseren Thermoschockbeständigkeit aufweisen.

Wiederaufarbeitung (Refurbishment) bedeutet, dass Hitzeschildelemente 155 nach ihrem Einsatz gegebenenfalls von Schutzschichten befreit werden müssen (z.B. durch Sandstrahlen). Danach erfolgt eine Entfernung der Korrosions- und/oder Oxidationsschichten bzw. -produkte. Gegebenenfalls werden auch noch Risse in dem Hitzeschildelement 155 repariert. Danach erfolgt eine Wiederbeschichtung der Hitzeschildelemente 155 und ein erneuter Einsatz der Hitzeschildelemente 155.

Aufgrund der hohen Temperaturen im Inneren der Brennkammer 110 kann zudem für die Hitzeschildelemente 155 bzw. für deren Halteelemente ein Kühlsystem vorgesehen sein. Die Hitzeschildelemente 155 sind dann beispielsweise hohl und weisen ggf. noch in den Brennkammerraum 154 mündende Kühllöcher (nicht dargestellt) auf.

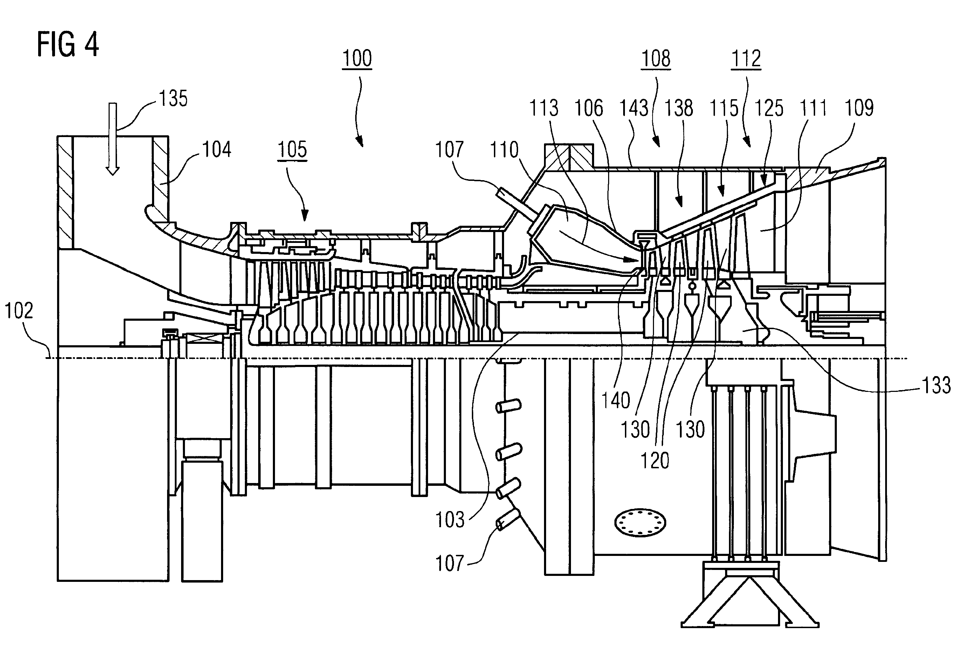

Die Figur 4 zeigt beispielhaft eine Gasturbine 100 in einem Längsteilschnitt.
Die Gasturbine 100 weist im Inneren einen um eine Rotationsachse 102 drehgelagerten Rotor 103 mit einer Welle 101 auf, der auch als Turbinenläufer bezeichnet wird.
Entlang des Rotors 103 folgen aufeinander ein Ansauggehäuse 104, ein Verdichter 105, eine beispielsweise torusartige Brennkammer 110, insbesondere Ringbrennkammer, mit mehreren koaxial angeordneten Brennern 107, eine Turbine 108 und das Abgasgehäuse 109.
Die Ringbrennkammer 110 kommuniziert mit einem beispielsweise ringförmigen Heißgaskanal 111. Dort bilden beispielsweise vier hintereinander geschaltete Turbinenstufen 112 die Turbine 108.

Jede Turbinenstufe 112 ist beispielsweise aus zwei Schaufelringen gebildet. In Strömungsrichtung eines Arbeitsmediums 113 gesehen folgt im Heißgaskanal 111 einer Leitschaufelreihe 115 eine aus Laufschaufeln 120 gebildete Reihe 125.

Die Leitschaufeln 130 sind dabei an einem Innengehäuse 138 eines Stators 143 befestigt, wohingegen die Laufschaufeln 120 einer Reihe 125 beispielsweise mittels einer Turbinenscheibe 133 am Rotor 103 angebracht sind.
An dem Rotor 103 angekoppelt ist ein Generator oder eine Arbeitsmaschine (nicht dargestellt).

Während des Betriebes der Gasturbine 100 wird vom Verdichter 105 durch das Ansauggehäuse 104 Luft 135 angesaugt und verdichtet. Die am turbinenseitigen Ende des Verdichters 105 bereitgestellte verdichtete Luft wird zu den Brennern 107 geführt und dort mit einem Brennmittel vermischt. Das Gemisch wird dann unter Bildung des Arbeitsmediums 113 in der Brennkammer 110 verbrannt. Von dort aus strömt das Arbeitsmedium 113 entlang des Heißgaskanals 111 vorbei an den Leitschaufeln 130 und den Laufschaufeln 120. An den Laufschaufeln 120 entspannt sich das Arbeitsmedium 113 impulsübertragend, so dass die Laufschaufeln 120 den Rotor 103 antreiben und dieser die an ihn angekoppelte Arbeitsmaschine.

Die dem heißen Arbeitsmedium 113 ausgesetzten Bauteile unterliegen während des Betriebes der Gasturbine 100 thermischen Belastungen. Die Leitschaufeln 130 und Laufschaufeln 120 der in Strömungsrichtung des Arbeitsmediums 113 gesehen ersten Turbinenstufe 112 werden neben den die Ringbrennkammer 110 auskleidenden Hitzeschildelementen am meisten thermisch belastet.
Um den dort herrschenden Temperaturen standzuhalten, können diese mittels eines Kühlmittels gekühlt werden.
Ebenso können Substrate der Bauteile eine gerichtete Struktur aufweisen, d.h. sie sind einkristallin (SX-Struktur) oder weisen nur längsgerichtete Körner auf (DS-Struktur).

Als Material für die Bauteile, insbesondere für die Turbinenschaufel 120, 130 und Bauteile der Brennkammer 110 werden beispielsweise eisen-, nickel- oder kobaltbasierte Superlegierungen verwendet.
Solche Superlegierungen sind beispielsweise aus der EP 1 204 776 B1, EP 1 306 454, EP 1 319 729 A1, WO 99/67435 oder WO 00/44949 bekannt; diese Schriften sind bzgl. der chemischen Zusammensetzung der Legierungen Teil der Offenbarung.

Ebenso können die Schaufeln 120, 130 Beschichtungen gegen Korrosion (MCrA1X; M ist zumindest ein Element der Gruppe Eisen (Fe), Kobalt (Co), Nickel (Ni), X ist ein Aktivelement und steht für Yttrium (Y) und/oder Silizium, Scandium (Sc) und/oder zumindest ein Element der Seltenen Erden bzw. Hafnium). Solche Legierungen sind bekannt aus der EP 0 486 489 B1, EP 0 786 017 B1, EP 0 412 397 B1 oder EP 1 306 454 A1, die bzgl. der chemischen Zusammensetzung Teil dieser Offenbarung sein sollen.

Auf der MCrAlX kann noch eine Wärmedämmschicht vorhanden sein, und besteht beispielsweise aus ZrO₂, Y₂O₃-ZrO₂, d.h. sie ist nicht, teilweise oder vollständig stabilisiert durch Yttriumoxid und/oder Kalziumoxid und/oder Magnesiumoxid.
Durch geeignete Beschichtungsverfahren wie z.B. Elektronenstrahlverdampfen (EB-PVD) werden stängelförmige Körner in der Wärmedämmschicht erzeugt.

Die Leitschaufel 130 weist einen dem Innengehäuse 138 der Turbine 108 zugewandten Leitschaufelfuß (hier nicht dargestellt) und einen dem Leitschaufelfuß gegenüberliegenden Leitschaufelkopf auf. Der Leitschaufelkopf ist dem Rotor 103 zugewandt und an einem Befestigungsring 140 des Stators 143 festgelegt.

## Patentansprüche

1. Verfahren zur Herstellung von Werkstücken,
insbesondere von Turbinenschaufeln (1),
bei dem das Werkstück (1) vor dem Aufbringen einer insbesondere keramischen Beschichtung mit einer Abdeckung über Bohrungsbereiche versehen wird, die für Bohrungen (4) vorgesehen sind oder wo Bohrungen (4) vorhanden sind,
welche nach der Beschichtung nachbearbeitet werden und bei dem die Abdeckung nach dem Beschichten wieder entfernt wird,
**dadurch gekennzeichnet, dass**
zur Herstellung der Abdeckung über die Bohrungsbereiche wenigstens ein stab- oder streifenförmiges Abdeckelement (6) gelegt und an dem Werkstück (1) mittels Klebstoff (5) befestigt wird, der sich zumindest über die Bohrungsbereiche erstreckt,
wobei Abdeckelement(e) (6) und Klebstoff (5) gegenüber den bei der Beschichtung herrschenden Temperaturen beständig sind.

2. Verfahren nach Anspruch 1,
**dadurch gekennzeichnet, dass**
ein Abdeckelement (6) verwendet wird, das sich über eine Reihe von Bohrungsbereichen erstreckt.

3. Verfahren nach Anspruch 1 oder 2,
**dadurch gekennzeichnet, dass**
als Abdeckelemente Abdeckdrähte (6) verwendet werden.

4. Verfahren nach einem der Ansprüche 1 bis 3,
**dadurch gekennzeichnet, dass**
Abdeckelemente (6) aus PTFE, Keramik, Glasfaser oder dgl. verwendet werden.

5. Verfahren nach einem der Ansprüche 1 bis 4,
**dadurch gekennzeichnet, dass**
der Klebstoff (5) so aufgetragen wird, dass er ausschließlich die Bohrungsbereiche abdeckt.

6. Verfahren nach einem der Ansprüche 1 bis 5,
**dadurch gekennzeichnet, dass**
der Klebstoff (5) nach der Beschichtung des Werkstücks (1) ausgebrannt wird.

7. Verfahren nach Anspruch 6,
**dadurch gekennzeichnet, dass**
vor dem Ausbrennen des Klebstoffs (5) das bzw. die Abdeckelement(e) (6) entfernt wird bzw. werden.

8. Verfahren nach einem der Ansprüche 1 bis 7,
**dadurch gekennzeichnet, dass**
ein Klebstoff (5) verwendet wird, der bis zu 400°C beständig ist.

9. Verfahren nach einem der Ansprüche 1 bis 8,
**dadurch gekennzeichnet, dass**
ein mittels UV-Licht aushärtbarer Klebstoff (5) verwendet wird.
